**Europäisches Patentamt**

**European Patent Office**

**Office européen des brevets**

(19)

(11) Publication number : **0 435 653 B1**

# EUROPEAN PATENT SPECIFICATION

(12)

(45) Date of publication of patent specification :
01.06.94 Bulletin 94/22

(51) Int. Cl.⁵ : **F04B 43/04, F04B 21/02**

(21) Application number : **90314255.2**

(22) Date of filing : **24.12.90**

(54) Micropump.

(30) Priority : **27.12.89 JP 340469/89**
**31.01.90 JP 19241/90**
**31.01.90 JP 19242/90**
**08.02.90 JP 27170/90**

(43) Date of publication of application :
**03.07.91 Bulletin 91/27**

(45) Publication of the grant of the patent :
**01.06.94 Bulletin 94/22**

(84) Designated Contracting States :
**CH DE FR GB LI NL**

(56) References cited :
**WO-A-90/15929**
**WO-A-91/01464**
**FR-A- 2 352 966**
**US-A- 4 596 575**
**SENSOR AND ACTUATORS. vol. 15, no. 2,**
**October 1988, Lausanne, CH, p. 153-167; van**
**Lintel: "A piezoelectric micropump based on**
**micromachining of silicon "**
**SENSOR AND ACTUATORS. vol. 20, no. 1/2, 15**
**November 1989, Lausanne, CH, p. 163-169;**
**Masayoshi Esashi & Co.: & Co.: "NORMALLY**
**CLOSED MICROVALVE AND MICROPUMP**
**FABRICATED ON A SILICON WAFER"**

(73) Proprietor : **SEIKO EPSON CORPORATION**
**4-1, Nishishinjuku 2-chome**
**Shinjuku-ku Tokyo (JP)**

(72) Inventor : **Miyazaki, Hajime**
**3-5 Owa, 3-chome**
**Suwa-shi, Nagano-ken (JP)**
Inventor : **Handa, Masaaki**
**3-5 Owa, 3-chome**
**Suwa-shi, Nagano-ken (JP)**
Inventor : **Uehara, Taisuke**
**3-5 Owa, 3-chome**
**Suwa-shi, Nagano-ken (JP)**
Inventor : **Muranaka, Tsukasa**
**3-5 Owa, 3-chome**
**Suwa-shi, Nagano-ken (JP)**
Inventor : **Kamisuki, Shinichi**
**3-5 Owa, 3-chome**
**Suwa-shi, Nagano-ken (JP)**
Inventor : **Nose, Yasuto**
**3-5 Owa, 3-chome**
**Suwa-shi, Nagano-ken (JP)**

(74) Representative : **Miller, Joseph et al**
**J. MILLER & CO.**
**34 Bedford Row,**
**Holborn**
**London WC1R 4JH (GB)**

## Description

The present invention relates to a micropump and, although it is not so restricted, it relates more particularly to a micropump for use in the field of medicine and analysis.

Micromachining technology is nowadays developing and its study is advancing in order to make use of it as a way of developing novel and high technologies. It attracts attention in the media, for example, in a feature article entitled "Si Micromachining Technology" in NIKKEI ELECTRONICS No. 480 (published on August 21, 1989), Pages 125-155.

The part of the article from pages 135-139 refers to micropumps and part of it explains the construction of a micropump.

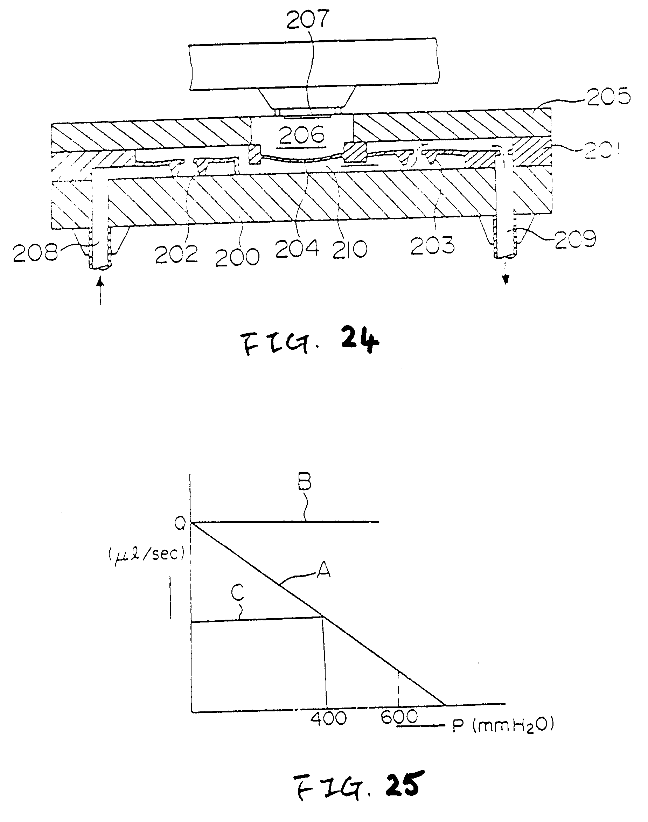

Figure 24 is a sectional view of the micropump referred to in the article. This construction of micropump has a glass substrate or base plate 200, an Si membrane 201, and a glass plate 205, which are respectively bonded together in this order. The membrane 201 has two valves 202 and 203, and a diaphragm 204 formed between these valves as shown. The diaphragm is adapted to be driven by an exothermic resistor 207 through an air layer 206. The glass substrate 200 has an inlet port 208 and an outlet port 209, respectively, which communicate with the valves 202 and 203. When air in the air layer 206 expands thermally and the diaphragm 204 protrudes downwards so as to raise the pressure in a pump chamber 210, the inlet valve 202 is closed and simultaneously the outlet valve 203 opens, so that pressure fluid in the pump chamber 210 is discharged to the outlet port 209. On the contrary, when the air layer 206 shrinks and the diaphragm 204 returns to its original or previous condition, the valves 202 and 203 respectively function in the reverse manner, so that the inlet port 208 sucks fluid and the outlet port 209 is prevented from discharging fluid.

Such micropumps can control precisely and finely a volume of fluid flowing through them and can be used in the fields of medicine and analysis so that development of them has been expected.

A method of manufacturing micromechanical devices including micropumps is described in the latter portion of the article above of NIKKEI ELECTRONICS, No. 480. That is, pages 146-149 discloses a machining method (aerotropic etching and the like) for forming a complicated three-dimension construction of Si (silicon) by using effectively semiconductor etching technology, and pages 150-152 discloses substrates jointing technology (anode jointing method for combining or securing together substrates of glass and silicon) for making various shapes of joined substrates.

Silicon-made pressure sensors have been developed as micromechanical devices and at present they are employed in practice. However, in the field of micropumps, the most advanced one is presently at its trial manufacture stage and no micropump in practice exists at present. In consequence, the manufacturing method of micropumps is at its groping stage and no established and reliable method is of avail.

As mentioned above, micropumps are still advancing, so that development and research are necessary to study the construction and method of manufacturing high-performance micro-pumps.

In the prior art micropumps mentioned above, the construction has the following shortcomings.

First, as regards the problem of the discharge performance of the micropump, the two-valve type of micropump shown in Figure 24 has the problem of the gradual lowering of the flow volume of fluid due to the pressure difference between the inlet port and the outlet port, which reduces the efficiency of the micropump.

Figure 25 shows the characteristics curves printed on page 136 of the publication mentioned above, showing that a flow volume Q of a two-valve type micropump linearly decreases with increase of the pressure difference P (line A). In the case of the two-valve micropumps, however, the pressure difference acts directly on the outlet valve, and the outlet valve is therefore strongly urged towards its closing direction.

As described above, when the two-valve type micropump is used, for example, to dose insulin and the back pressure becomes about 600 mmH$_2$0, the micropump cannot discharge the insulin. In practice, it is necessary to discharge fluid substantially at a constant rate until the back pressure becomes about 400 mmH$_2$0. This is the reason why it is necessary for there to be development in micropumps.

The second problem concerns the method of fixing the micropump drive apparatus in position. The prior art fixing method has proved very difficult to achieve, often resulting in incomplete and ineffective installation of the drive apparatus. In general, piezoelectric elements, which are preferable in their controllability, have been used in drive apparatus for other purposes. In this situation, in order to obtain sufficient piezo-electric effect, it is necessary to uniformly bond the piezo-electric element to a diaphragm of the micropump drive mechanism. The bonding of a very thin membrane to the diaphragm, however, has been very difficult. The reason is that, because the diaphragm is supported by fixing it at its peripheral portion, the diaphragm is apt to bend or flex, resulting in deterioration of its flatness in the course of bonding the piezo-electric element to the diaphragm. As a result, poor bonding is attained between the piezo-electric element and the diaphragm. If the piezo-electric element is pressed under excessive pressure against the diaphragm, the peripheral portions of the diaphragm are liable to be damaged. It is difficult to control the force with which the piezo-electric element is pressed against the diaphragm resulting in a difficult bonding operation.

The third problem concerns keeping constant the discharge performance of the known micropump, in particular, when the micropump is used to dose human beings with insulin. Over-dosing human beings with insulin is a dangerous problem. In consequence, it is necessary to detect immediately any mis-operation of the injections due to breakdown of the micropump drive apparatus, blockage in a needle fixed to the micropump, mixture with the air in the pump, and breakage of valves. However, no such detecting means is provided in the known micro-pumping apparatus.

Next, consideration will be given with respect to the manufacture of micropumps which have a main thin membrane comprising a diaphragm which constitutes the main member of the pump and a valve membrane integrally formed of the same material (silicon single crystal) as that of the diaphragm, and glass substrates between which the main thin membrane is sandwiched. There is no problem in the manufacture of the diaphragm because it is manufactured using the know-how and the experience obtained when silicon pressure sensors are manufactured. However, the valve membrane has a part formed in a narrow zone which constitutes a valve portion, through which zone the glass substrates can come in contact with each other except for a small gap therebetween, so reducing the sealing effect of the construction. Apparently, it is necessary to subject the construction to pre-pressure but there has been no suitable means to provide such pre-pressure.

When a glass plate and the main thin membrane are secured to each other through an anode jointing step, the valve portion too may be accidentally secured to the glass plate, making the valve body useless.

According to the present invention, there is provided a micropump comprising a substrate having an inlet port and an outlet port; pump plate means mounted on the substrate , portions of the pump plate means forming an inlet valve and an outlet valve which respectively control flow through the inlet port and the outlet port, the outlet valve covering an inlet of the outlet port so that, when the outlet valve is closed, it caps the outlet port; a diaphragm which is an integral part of the pump plate means and which forms at least part of a wall of a pump chamber in the pump plate means, the pump plate means having conduit means for the flow of fluid from the inlet port and via the pump chamber to the outlet port; and drive means for effecting pumping movement of the diaphragm, the outlet valve being provided with an outlet valve chamber which communicates with the inlet port, and fluid in the outlet valve chamber urging the outlet valve towards its closed position, characterised in that the pump plate means has an annular inlet valve chamber therein which surrounds the inlet valve and which communicates with the outlet valve chamber.

The pump plate means may be constituted by a single plate member.

The drive means preferably comprises a piezoelectric element secured to the diaphragm.

The pump plate means may be sandwiched between the substrate and a top plate.

Preferably, the outlet valve is provided with a detection member for detecting the position or behaviour of the outlet valve.

The inlet valve may, if desired cover an inlet of the inlet port so that, when the inlet valve is closed, it caps the inlet port.

The substrate may comprise both a base plate and a support plate mounted on the base plate, the support plate supporting the pump plate means and being provided with transversely extending inlet and outlet ports.

The pump plate means may, if desired, comprise first and second plates, the first plate being provided with the inlet valve and the pump chamber, and the second plate being provided with the outlet valve.

The diaphragm is preferably provided adjacent its centre with a support member or a support portion engageable with the substrate.

Detection means are preferably provided for detecting strain in the drive means and/or for detecting mechanical displacement of the diaphragm.

At least one of the valves may be provided with or may engage a member for assisting the sealing of the valve to the substrate and/or for preventing undesired adherence therebetween.

In its preferred form, the micropump of the present invention has a flow rate characteristic which is almost constant in the range of the predetermined use of the pump. The preferred micropump enables detection and control to be effected of the open-and-close operation of the valves and provides a more stable and firm degree of sealing in the valves.

The preferred micropump, moreover, has a construction in which it is always possible to detect the operative condition of the micropump in order to attain normal or correct operation in the micropump.

A micropump according to the present invention in one particular form thereof has a substrate; a thin membrane secured to the upper face of the substrate, which membrane has an inlet port and an outlet port, an inlet valve and an outlet valve, each carrying out opening and closing of the inlet port and the outlet port, a diaphragm forming a pump chamber, and a flow conduit through which fluid flows; a surface plate secured to an upper surface of the thin membrane; and a drive means for driving the diaphragm; the outlet valve being constituted by a cap-shaped valve body covering an inlet of the outlet port.

The micropump may be such that the direction of force for raising the valve body at the outlet valve by means of the back pressure and another direction of force functioning to raise a partition wall having the outlet valve, such forces being produced by means of the pressurized fluid from the pump chamber, are identical to each other, so that it is possible to discharge at an almost constant flow rate within the practical range of use of the micropump until the back pressure overcomes the sealing force previously given.

It is appropriate to use a compact and easy to control piezo-electric element as a drive means for the diaphragm of the micropump. The piezo-electric element fixed to the diaphragm oscillates to vibrate the diaphragm up-and-down so as to apply a pressure to the pump chamber, so that the pump quickly operates without fear of the temperature of the fluid rising.

It is possible for the input fluid to be led directly into a chamber having the inlet port valve. However, the input fluid is preferably led to a chamber at the side of the inlet port valve after having been led to another chamber formed above a partition wall of the outlet port valve. When a sudden outside force is imparted to the liquid contained, for example, in a reservoir connected to the micropump, it is possible to transfer the sudden pressure change to the chamber above the partition wall of the outlet valve and, a positive closing of the outlet valve prevents the fluid from discharging through the outlet valve.

Further, it is possible to establish communication between the pump chamber and the chamber provided above a partition wall of the inlet valve and the chamber having the outlet valve. In this construction, the pressure in the pump chamber is transferred simultaneously to the other two chambers, so that the open-and-shut operations of the outlet and inlet valves are periodically and surely carried out. In order to detect and control the open-and-shut operations of the outlet valve, at least the top surface of the partition wall of the outlet valve may be exposed to the atmosphere. It is possible to secure to the partition wall something that is able to detect any movement of the partition wall, such as a piezo-electric element similar to the drive piezo-electric element or a strain gauge. It is possible to construct the inlet valve in the form of a valve body of a cap shape, similar to that of the outlet valve, covering an outlet of the inlet port. Thus a piezo-electric element disposed on the partition wall of the outlet valve can positively control the open-and-shut operation of the outlet valve, resulting in a more stable state of sealing of the outlet valve.

When an intermediate substrate is provided between the first-mentioned substrate and the thin membrane plate, which intermediate substrate is made of the same material as of the thin membrane plate, the intermediate substrate may be etched to position and extend the inlet port and outlet port transversely sideways of the intermediate substrate, so that tubes to be connected to these ports can be handled easily.

When there can be some allowance in the size of the height (thickness) of the micropump relative to its horizontal area, it is possible to make the thin membrane plate of a two-layer construction with an intermediate substrate inserted between them. In this case, the upper thin membrane plate has an inlet valve and a pump chamber, and the lower thin membrane plate has an outlet valve. The intermediate substrate has a flow conduit between the inlet port and the chamber of the inlet valve, and another flow conduit between the pump chamber and an outlet valve chamber, respectively formed therein. The pumping function or operation of such a layered micropump is the same as that of the flat or one-layer micropump.

When a support is provided at the centre of the diaphragm, and the end of the support is arranged to come into contact with the substrate, the support functions as a stopper in the process of securing a piezo-electric element for driving the diaphragm to the diaphragm. Thus the support provides sufficient resistance to the force with which the drive piezo-electric element is pressed against the diaphragm during manufacture, this force also being resisted by the peripheral portions of the diaphragm where the latter is joined to the surface plate. As a result, it is possible to maintain the flatness of the surface of the diaphragm during the adherence thereto of a piezo-electric element, so that the adherence of the drive piezo-electric element can be effected uniformly and stably without difficulty. Although the support may usually be shaped as a rod, it is possible to alter the shape to a cylindrical one or to provide it in the form of a convex projection disposed diametrically on the diaphragm, so obtaining greater stability in the support of the diaphragm. It is also possible to make the diaphragm proper come into direct contact with the substrate to support the diaphragm, so obtaining a similar operative effect to the shape of support above.

If the diaphragm has such a support and the diaphragm itself comes into contact with the substrate, so that the diaphragm itself acts as a stopper, the amplitude of the diaphragm is always affected by the contact, so obtaining a stable and constant-volume charge. In particular, the diaphragm has only half oscillations due to the stopper, so that the discharge volume per one cycle or amplitude decreases. However, it is possible to increase the total discharge volume of the micropump according to the present invention by increasing the number of discharge cycles and/or by raising the drive voltage, so that there is no problem in its practical use.

When the support and the diaphragm are separated, the support may be shaped as a cylindrical projection and may be integrally formed on the thin membrane plate. In this case, the front ends of the projection come in contact with the central portion of the diaphragm. The projection functions as a stopper as mentioned above and as a flow rate control valve by forming a central opening in the projection and the fluid flow or discharge is effected at a fixed rate to the output side.

Further, when a detection means for detecting the behaviour or motion of the drive piezo-electric element is mounted on the diaphragm, it is possible to determine correctly the oscillation waveshapes of the diaphragm and to judge whether the behaviour is right or normal, or is wrong or abnormal. The same principle can be applied to the outlet valve member. It is convenient to use an economical piezo-electric element as the detection means. The detection piezo-electric element may be fixed to a vibrating surface plate connected to the partition wall of the outlet valve by way of a vibration transferring projection or to fix it directly to the partition wall.

These diaphragm detection means and valve detection means may be used by themselves or in combination in the micropump of the present invention. The detection means may have a detection circuit which compares the detected waveshape to the standard voltage in the period from the rising of the waveshape in a plurality of stages at regular intervals, and which judges whether the flow is normal or abnormal by the order of the highs and lows. According to the method of judging the result detected, it is possible to judge the detected waveshape through its rising curve after it is amplified. In particular the waveshapes may be compared to a standard voltage in a plurality of stages at regular intervals by seeing the order of highs (H) and lows (L). For example, when the order of waves of L-H-H is obtained, it is considered that the flow is normal, and when the wave height order differs from the normal order, it is judged abnormal.

It is preferable to provide an adhering member on the substrate or on the valves in order to give a pre-pressure to the sealing portion of the inlet and the outlet valves so as to improve the sealing effect.

The invention also includes a method of manufacturing a thin membrane plate forming a main member of a micropump main body, the method including the step of forming the thin membrane plate from a silicon wafer of (100) face-direction having a diaphragm, conduits and valves of predetermined sizes which are respectively formed integrally with the wafer, and another step of forming an adhering membrane for giving a pre-pressure to the valves by means of mask-spattering effectively only the valve portions of the valves which contact a surface of the substrate.

By forming the thin membrane plate of the micropump from a silicon wafer of (100) face-direction by means of a wet-type anisotropy etching process, it is easy to form deep grooves of easy-machinability which have a constant taper angle (54.7 degrees), and which further have flat bottoms. Thus, it is possible to make valve portions and pump construction portions of suitable shapes and structures.

Because adhering membranes are deposited by means of a mask spattering step on the valve portions which come in contact with the glass substrate of the thin membrane plate before the valve portions are assembled, the valve portions do not come into contact with the glass substrate when they are assembled by an anode jointing step between the glass substrate and the thin membrane plate. Owing to the adhering membranes, a pre-pressure is given to the valve portions of the valves as described above, so that the sealing effect between the glass substrate and the valves portion is improved.

The invention is illustrated, merely by way of example, in the accompanying drawings, in which:-

Figure 1 is a sectional view of a first embodiment of a micropump according to the present invention;

Figure 2 is a transverse or cross-sectional view taken along line A-A shown in Figure 1;

Figure 3 is a cross-sectional view taken along line B-B in Figure 1;

Figure 4 is a block diagram showing an embodiment of a drive circuit for driving a piezo-electric element used in the said first embodiment;

Figures 5(a) and 5(b) are sections similar to Figure 1 but illustrating operational states of the Figure 1 construction;

Figure 6 is a sectional view of a second embodiment of a micropump according to the present invention using a dielectric as a pump-drive means;

Figure 7 is a sectional view of a third embodiment of a micropump according to the present invention having a transverse inlet port and a transverse outlet port;

Figure 8 is a section showing a fourth embodiment of a micropump according to the present invention;

Figure 9 is a section taken along line C-C in Figure 8;

Figures 10(a) - (c), respectively show views of the operation of the embodiment shown in Figure 8;

Figure 11 is a sectional view of a fifth embodiment of a micropump according to the present invention provided with a cylindrical projection support;

Figure 12 is a sectional view of a sixth embodiment of a micropump according to the present invention having a convex projecting support;

Figure 13 is a sectional view of a seventh embodiment of a micropump according to the present invention using the diaphragm proper as a support;

Figure 14 is a sectional view of an eighth embodiment of a micropump according to the present invention employing a diaphragm-applied detecting device;

Figure 15 is a block diagram of the circuit employed in the embodiment shown in Figure 14;

Figures 16(a) and 16(b) are views illustrating the operation of the embodiment of Figure 14;

Figure 17 is a graph illustrating output waveforms;

Figure 18(a) shows the waveform of voltage pulses to be impressed on a diaphragm driving piezo-electric element;

Figure 18(b) shows an output waveform of the diaphragm detection piezo-electric element;

Figure 19 illustrates the relationship between disorders of the micropump and output waveforms at various positions at which the disorders are detected;

Figure 20 shows a ninth embodiment of a micropump according to the present invention in which there is a sealing portion of the inlet port valve and the outlet port valve;

Figures 21(a) - (i) respectively are sections showing steps in a method of manufacturing the thin membrane plate of the micropump according to the present invention;

Figure 22 is a sectional view illustrating how to use a thin membrane plate in constructing a micropump according to the present invention;

Figure 23 is a cross-sectional view of Figure 22;

Figure 24 is a sectional view of a known micropump; and

Figure 25 is a characteristic diagram showing the pump performances of both the prior art and the present invention.

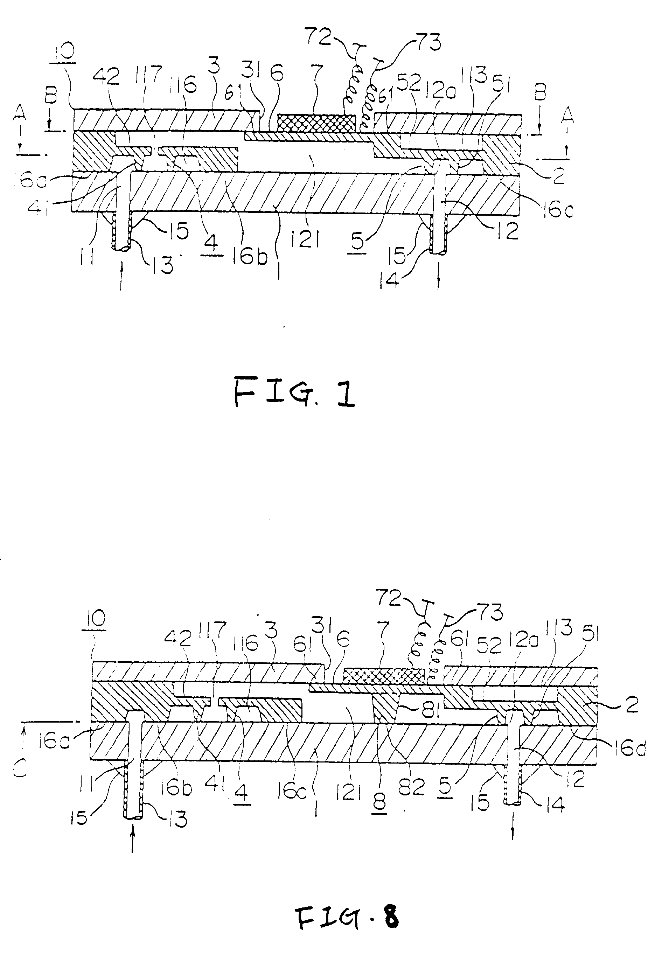

In Figures 1 - 3 there is shown a first embodiment of a micropump 10 according to the present invention which comprises a substrate 1, a thin membrane plate or pump plate 2 which is mounted on the substrate 1, and a surface or top plate 3, the membrane plate 2 being sandwiched between the substrate 1 and surface plate 3.

The substrate 1 is made of a glass plate of, for example, a thickness of about 1mm and it has an inlet port 11 and an outlet port 12 formed therein. Tubes 13 and 14 are water-tightly bonded to the ports 11 and 12 by bonds 15. The lower end of the tube 13 is connected, for example, to a chemical reservoir (not shown) and the outer end of the tube 14 is joined, for example, to an injection needle (not shown).

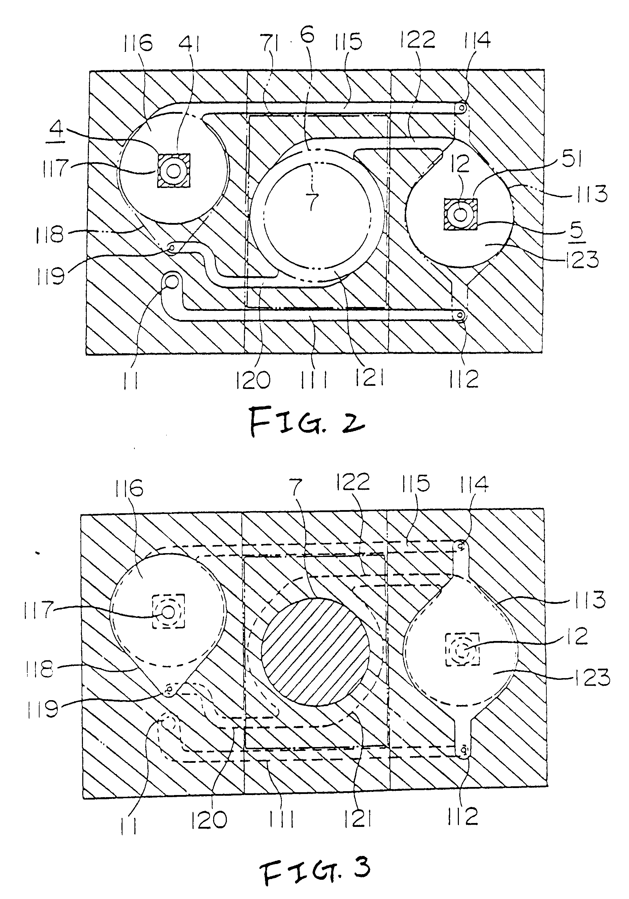

The thin membrane plate 2 consists of a Si (silicon) substrate of, for example, a thickness of about 0.3 mm. The membrane plate 2 has portions forming an inlet valve 4, an outlet valve 5 and a diaphragm 6 which is disposed between the valves 4 and 5. The diaphragm 6 forms a wall of a pump chamber 121 in the thin membrane plate 2. The thin membrane plate 2 has conduit means 111-120, 122 therein, as described below and as shown in Figures 2 and 3, for the flow of fluid from the inlet port 11 to the outlet port 12 via the pump chamber 121. The inlet valve 4 and outlet valve 5 respectively control flow through the inlet port 11 and the outlet port 12. The thin membrane plate 2 is formed by an etching process. The thin membrane plate 2 is joined to the upper surface of the substrate 1 by an anode jointing process. The jointing positions are depicted by 16a, 16b and 16c.

As clearly shown in Figures 2 and 3, the inlet port 11 formed in the thin membrane plate 2 has an input conduit 111 connected thereto, the conduit 111 leading via a passage hole 112 to a chamber 113 formed above the outlet valve 5. The chamber 113 communicates through another passage hole 114 with a conduit 115 leading to a chamber 116 of the inlet valve 4. The inlet valve 4 has a valve body 41 of regular square shape and it has a central through hole 117 leading to a chamber 118 above the valve body 41. The chamber 118 communicates via a through hole 119 and a conduit 120 with the pump chamber 121 below the diaphragm 6. Thus fluid pressurised in the pump chamber 121 flows to a chamber 123 of the out valve 5 by way of an output conduit 122. The outlet valve 5 is constructed of a cap-shaped and regular square valve body 51 in order to cover an inlet 12a of the outlet port 12. Thus when the outlet valve 5 is closed, it caps the outlet port 12.

A piezo-electric element 7 of a piezo-disc functioning as a drive means for the diaphragm 6 is secured to the upper surface of the diaphragm 6 through an electrode plate 71 constituted by a thin membrane. The piezo-electric element 7 is disposed in a recess 31 in the surface plate 3. 72 and 73 shown in Figure 1 are leads for impressing a voltage on the piezo-electric element 7.

The surface plate 3, made of a glass substrate similar to the substrate 1, is secured to an upper surface of the thin membrane plate 2 by an anode jointing process. Actuation of the piezo-electric element 7 produces vibration of the diaphragm 6 to effect pumping. The peripheral portion 61 of the diaphragm 6 is secured to the circumference of the recess 31 of the surface plate 3. The thickness of the surface plate 3 is about 0.5 mm.

Figure 4 is a block diagram showing one embodiment of a drive circuit for driving the piezo-electric element 7. As shown in Figure 4, the drive circuit consists of a power source 701 such as a lithium cell, a voltage step-up circuit 702, a CPU 703, a level shifter 704 for changing a low voltage signal to a high voltage signal, a driver 705 for driving the piezo-electric element 7, an indicator 706 for indicating the flow rate of the micropump, and a selection switch 707 for selecting the flow rate.

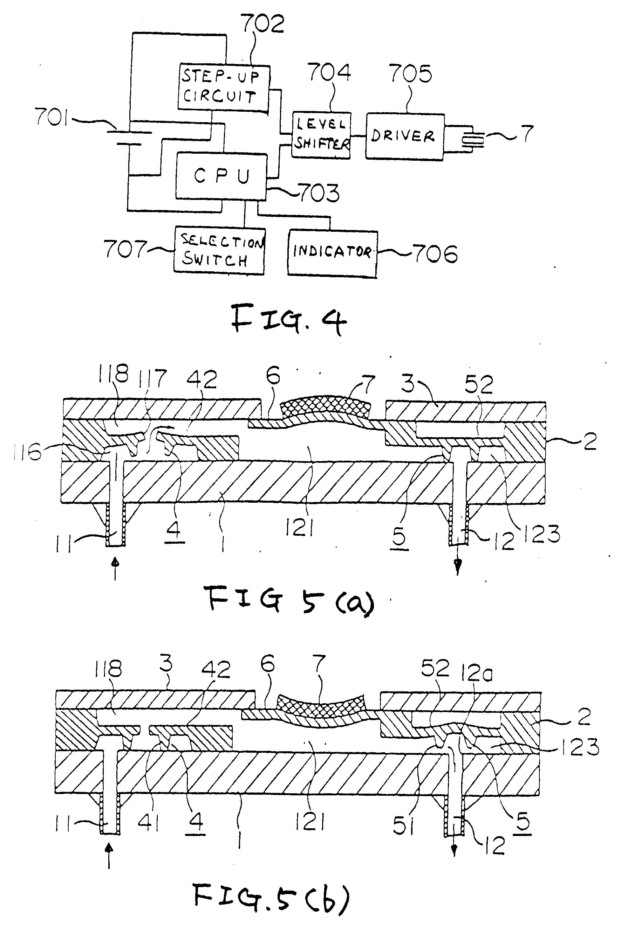

Figures 5(a) and 5(b) illustrate the operation of the said first embodiment. The operation of the first embodiment will now be explained with reference to Figures 4 and 5.

First, the flow rate is selected by the switch 707 and the CPU 703 outputs a micropump drive signal. The signal issued from the CPU 703 is generally at a voltage of 3 - 5V and the piezo-electric element 7 operates at a high voltage such as 50V. The step-up circuit 702 raises the voltage of 3V to 50V, and the level shifter 704 changes the signal from the CPU 703 to another signal of 50V.

In such a way, an alternating voltage of 50V is periodically impressed on the piezo-electric element 7 causing an oscillation ranging from 1 Hz to several Hz. When the diaphragm 6 bends or deflects upward as shown in Figure 5(a) due to the piezo-electric effect, the pressure in the pump chamber 121 is reduced. Consequently, a partition wall 52 of the chamber 123 deflects downwards so as to shut the outlet valve 5. At the same time as the outlet valve 5 closes, a partition wall 42 of the chamber 118 deflects or bends upward so as to open the inlet valve 4, resulting in a suction of fluid of a predetermined volume from the chamber 116 leading to the inlet port 11 through the through hole 117.

When the diaphragm 6 bends downward as shown in Figure 5(b) in contrast to its position in Figure 5(a), the pressure in the pump chamber 121 is raised and the raised pressure is transferred simultaneously to both of the chambers 118 and 123 through the conduits 120 and 122 in order to raise the pressure therein. The raised pressure within the chamber 118 causes the partition wall 42 having the inlet valve 4 to be pushed downward and to press the valve body 41 of the inlet valve 4 against the substrate 1, resulting in a closing of the inlet valve 4. Simultaneously, the raising of the pressure in the chamber 123 causes the partition wall 52 of the chamber 123 to be pushed up so that the valve body 51 of the outlet valve 5 is separated from the substrate 1. The outlet valve 5 is thus opened so that pressure fluid of a predetermined volume is discharged to the outlet port 12.

The diaphragm 6, which is oscillated by the piezo-electric element 7, continuously carries out the drawing in and discharging of the fluid. When the number of oscillations increases, a pumping operation can be obtained in which there is decreased pulsing in the fluid so that a smooth flow can be attained.

In the known two-valve type micropump the back pressure operates to close the outlet valve, so that the larger the back pressure, the larger the force necessary to open the outlet valve. When the piezo-electric element is driven to raise the pressure within the pump chamber, the amplitude of oscillation of the piezo-electric element is restricted, resulting in a decrease of the discharge flow volume in the known micropump with increase of discharge pressure. On the contrary, due to the fact that the outlet valve 5 of the said first embodiment is made of the cap-shaped valve body 51 covering the inlet 12a of the outlet port 12, the direction in which the partition wall 52 moves in order to open the outlet valve 5 under the back pressure of the outlet port 12 is made the same as the direction in which the pressure in the pump chamber 121 acts to push the partition wall 52, diminishing any restraint due to back pressure on the amplitude of oscillation of the piezo-electric element. It is apparent that the micropump of Figures 1-3 discharges continuously at an almost-constant flow rate within the range of the predetermined pump use or practice until the back pressure overcomes the resilient force of the outlet valve 5 and the pressure acting on the partition wall 52 due to outside force.

The pumping performance of the micropump of Figures 1 - 3 is shown in Figure 34 by the line B, the pumping performance of the known two-valve type micropump of Figure 3 being shown by the line C.

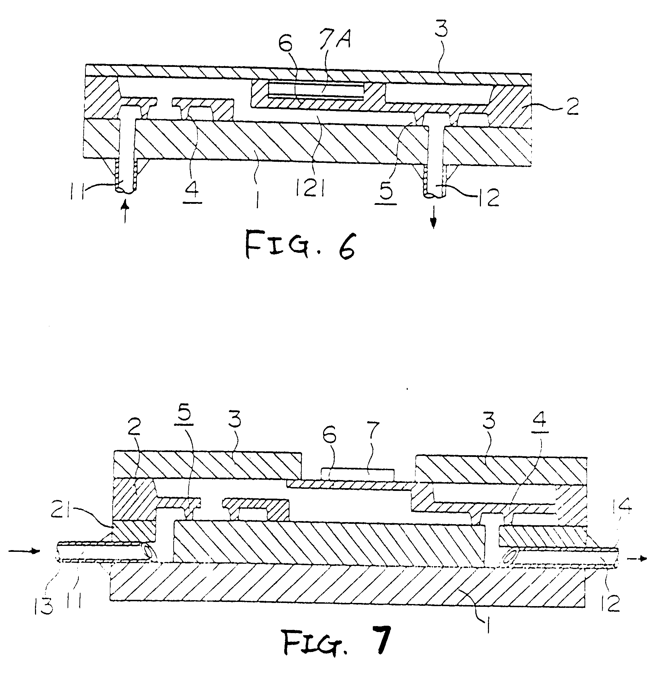

Figure 6 shows a second embodiment of a micropump according to the present invention which is generally similar to that of Figures 1 - 3. In the Figure 6 construction, however, a dielectric member 7A, in place of the piezoelectric element 7, functions as a drive means for the diaphragm 6. The diaphragm 6 is oscillated, as described above, by the static electricity of the dielectric 7A.

It is also possible to make the valve body 41 of the inlet valve 4 cap-shaped so as to cover the outlet 11a of the inlet port 11, similar to the outlet valve 5, thus attaining stabilised sealing and a thin construction of the micropump.

According to a third embodiment of a micropump according to the present invention shown in Figure 7, an additional intermediate substrate 21 made of silicon identical to the thin membrane plate 2 is placed between the substrate 1 and the thin membrane plate 2. An inlet port 11 and an outlet port 12 are respectively provided in the intermediate substrate 21 and extend transversely. The inlet port 11 and outlet port 12 are easily made in the intermediate substrate 21 at a lower cost by means of an etching process rather than by forming holes in the glass substrate 1 as described above. In addition, the construction of the micropump shown in Figure 7 comprises tubes 13 and 14 extending transversely or horizontally, so that the extended portions of the tubes are easier to accommodate and occupy smaller spaces around the construction.

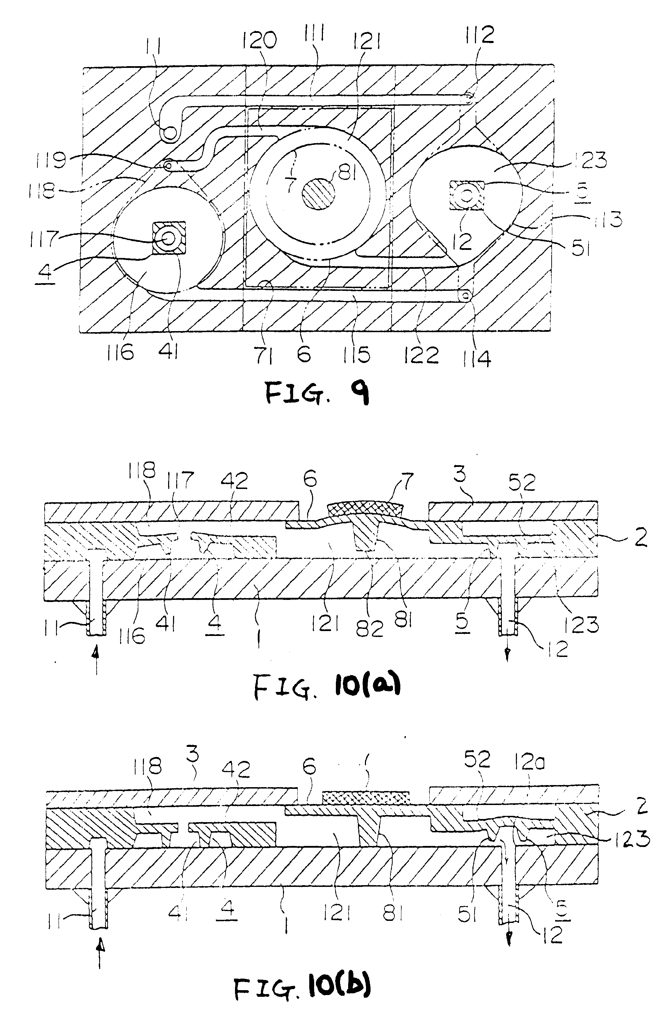

Figures 8 - 10 are sections showing a fourth embodiment of a micropump according to the present invention having a support formed at the centre of the diaphragm of the micropump, Figure 9 being a section taken along line C-C in Figure 8.

The embodiment shown in Figures 8 and 9 has a support 8 constituted by a rod-type projection 81 having a front (lower) end 82 which is adapted to contact the surface of the substrate 1, the projection 81 being formed at the centre of the diaphragm 6. The support 8 can be of any cross-sectional shape such as a circle or a square, etc.

In the position of the parts shown in Figure 8, the diaphragm 6 is supported both by its peripheral portion 61 which contacts the surface plate 3, and by the central support provided by the projection 81. Consequently, when the drive piezo-electric element 7 is secured to the diaphragm 6, the projection 81 functions as a pole or stopper and provides an adequate support to counter the force employed in securing the piezo-electric element 7, reducing the bending of the surface of the diaphragm 6. In other words, due to such support, the flatness of the surface of the diaphragm 6 is effectively maintained, so that the piezo-electric element 7 is bonded uniformly, completely, and securely. Moreover, even if the piezo-electric element 7 is subjected to a somewhat stronger force than normal during its adherence to the diaphragm 6, no damage will be imparted to the peripheral portion of the diaphragm 6 so making the assembly step easier.

The pumping and valving operation of the embodiment shown in Figure 8 is the same as that of the micropump shown in Figure 4 and 5 except for the following points.

Because the amplitude of oscillation of the diaphragm 6 is made constant by means of the stopper function of the projection 81 as shown in Figure 10(c) (see Figures 10(a) and (b)), a stable and constant flow can be obtained which is an improvement over that of the embodiment of Figure 1. In detail, although the diaphragm 6 oscillates with half of the amplitude due to the said stopping and the discharge volume per one oscillation is reduced, it is in practice possible to obtain the necessary discharge volume by increasing the number of discharge cycles and by increasing the driving electric voltage.

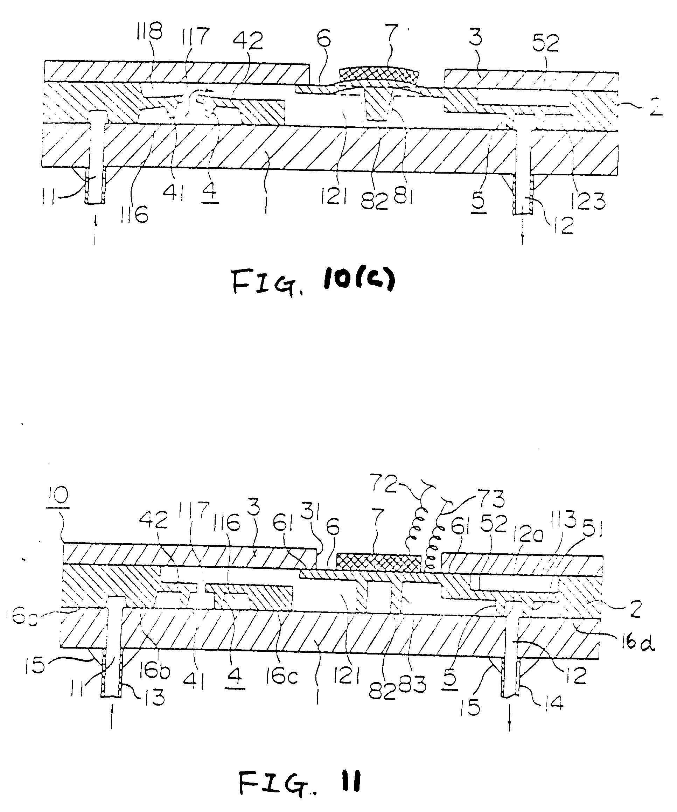

The support 8 can, if desired, be shaped as a cylindrical projection 83 formed coaxially with the diaphragm 6 as shown in Figure 11 which illustrates a fifth embodiment of a micropump according to the present invention. This construction makes the supported condition of the diaphragm 6 more stable and makes the operation of securing the drive piezo-electric element 7 to it stable and firm. It is possible to combine the particular construction shown in Figure 1 with the embodiment shown in Figure 8.

It is possible to provide a plurality of the rod-like projections 81 shown in Figure 8 and to arrange them along the diameter of the diaphragm 6.

As shown in the sixth embodiment of a micropump according to the present invention illustrated in Figure 12, it is easily possible to form a convex projection 84 which prevents fluid from flowing toward the outlet port 12 when a sudden pressure is produced from the direction of the inlet port 11. The projection 84 also provides the stopping function described above, and in addition prevents reverse-flow from the outlet valve 5.

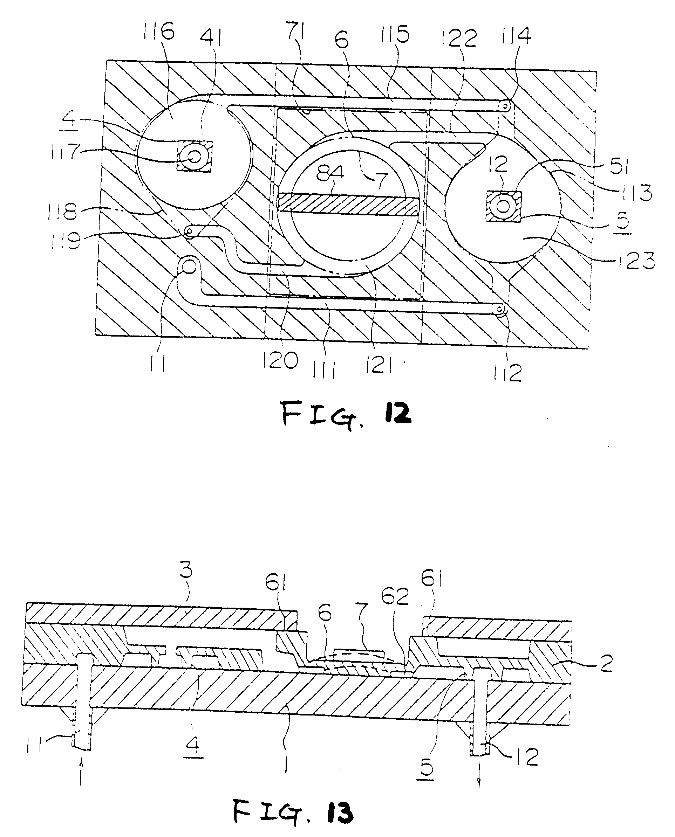

As is apparent from the above description, the respective projections 81, 83 and 84 are individually formed at the centre of the diaphragm 6 so as to be adapted to contact the substrate 1 by engagement at the ends of the projections. It is possible to eliminate these projections and make a part of the diaphragm 6 come in contact with the substrate 1. Such a construction is shown in a seventh embodiment of a micropump according to the present invention as illustrated in Figure 13.

In the embodiment shown in Figure 13, the whole of the lower surface of the diaphragm 6 is arranged to come in contact with the substrate 1, so that the adherence thereto of the piezo-electric element 7 can be effected more easily. In this case, the entire construction of the diaphragm 6 oscillates in the space shown in Figure 13 by broken lines so as to carry out a pumping function. It is to be noted that grooves 62 are formed as shown in Figure 13 at the sides of the conduit 120 (Figure 12) and of the output conduit 122 of the diaphragm 6 in order to allow fluid to flow through the grooves and gaps formed when the diaphragm 6 is displaced upwards.

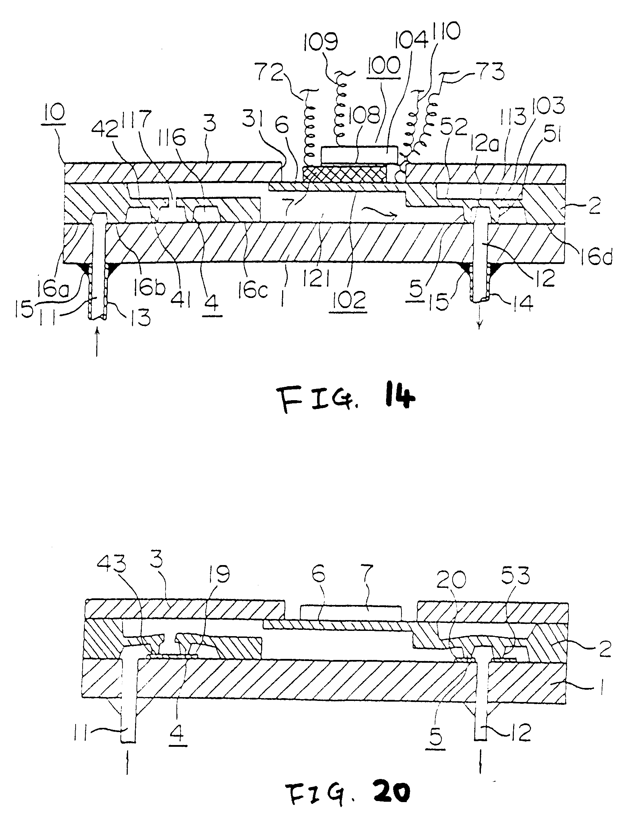

An eighth embodiment of a micropump according to the present invention which is provided with a detection device 100 will be explained with reference to Figure 14, the device 100 being adapted to detect behaviour of a diaphragm 102 of the micropump 10.

The detection device 100 consists of a piezo-electric element 104 identical to the piezo-electric element 7 for driving the diaphragm. The element 7 has the detection piezo-electric element 104 secured thereto with an insulation sheet 108 therebetween. The detection piezo-electric element 104 has leads 109 and 110.

The detection piezo-electric element 104 directly detects any strain in the drive piezo-electric element 7 and also any mechanical displacement of the diaphragm 6. It is to be noted that the detection piezo-electric element 104 may be provided economically.

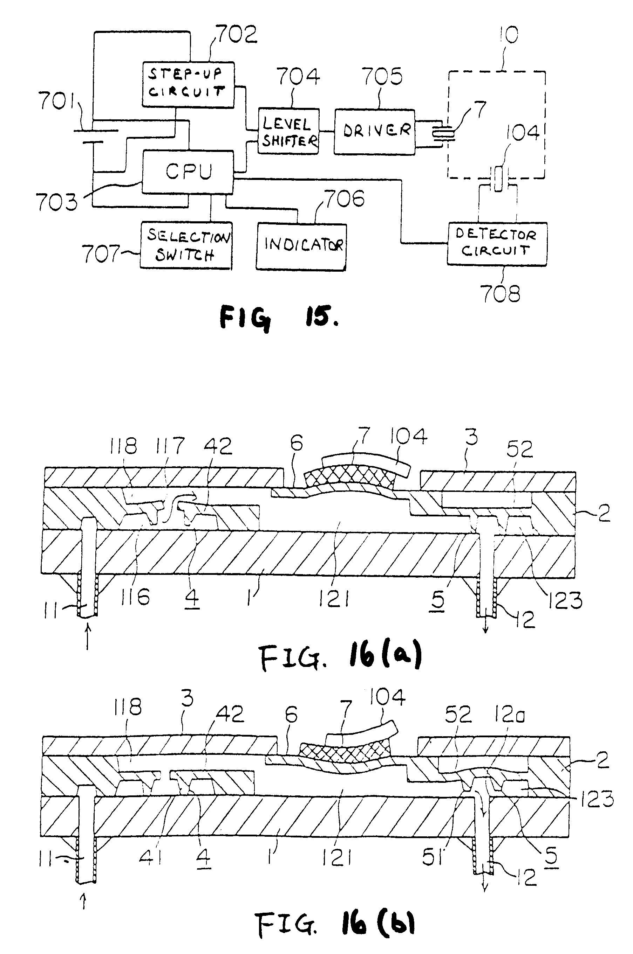

Figure 15 shows a circuit for actuating the drive piezo-electric element 7 of Figure 14 and for actuating the detection piezo-electric element 104 of the detection device 100. Figures 16(a) and 16(b) illustrate the operation of the micropump shown in Figure 14. It is to be noted that the valve detection device 101 also has a similar circuit structure.

The parts 701-707 in Figure 15 correspond to like numbered parts in Figure 4, and 708 shows a detection circuit which has been added.

The pumping and valving operation of the micropump of Figure 14 is substantially the same as that of Figures 4 and 5 (see Figures 16 (a) and 16 (b)). Operation of the detection device 100 and of the detection circuit 708 will, however, now be explained.

When a drive voltage is impressed on the piezo-electric element 7, the impression is instantly and with a predetermined timing read by the CPU 703 through the detection piezo-electric element 104 and the detection circuit 708. When any disorder is detected, the CPU 703 may issue a drive stop signal and a display device or indicator 706 displays the disorder.

The detection circuit 708 amplifies the voltage generated from the detection piezo-electric element 104, and compares High (H) and Low (L) (operation of a comparator in the circuit), sending the resultant signal to the CPU 703.

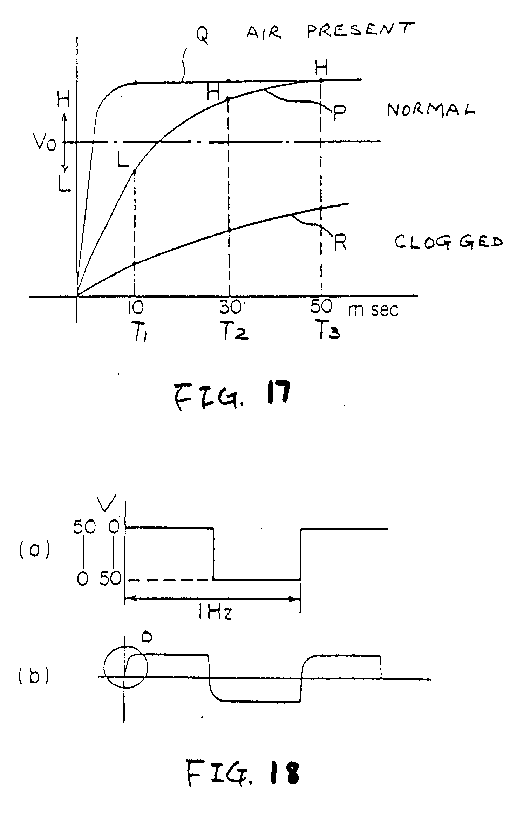

Figure 17 shows one example of the output waveshapes or curves of the detection piezo-electric element 104. In Figure 18(b) there is shown an enlarged rising portion D of the output of the detection piezo-electric element 104 for the diaphragm when an alternating voltage pulse of 50V, 1 Hz is impressed on the drive piezo-electric element 7 (see Figure 18(a)).

Figure 17 shows the waveshapes or curves of the case in which the micropump is at its normal condition (P), the condition (Q) in which air is contained in the micropump, and the condition (R) in which the mechanism of the micropump or of a needle is clogged with something. $V_o$ in Figure 17 shows a standard voltage which has been previously set in order to judge a disorder generation condition in the detection circuit 708. Such a disorder is judged according to the order of showing a low (L) or a high (H) of the voltage of the detection piezo-electric element 104 relative to the standard voltage $V_o$ in a period from a rising of the output pulse of the voltage for predetermined times $T_1$, $T_2$, and $T_3$.

The conditions when a disorder happens are detected as shown below. When, for example, $T_1$ = 10 m sec, $T_2$ = 30 m sec, and $T_3$ = 50 m sec, (the number or level of T may be selected at will), the following equations are generated;-

```
P (in normal case)
  (T , T , T ) = (L,  H,  H)
    1   2   3
              = (0,  1,  1)
Q (air is present)
  (T , T , T ) = (H,  H,  H)
    1   2   3
              = (1,  1,  1)
R (clogged with something)
  (T , T , T )  = (0,  0,  0)
    1   2   3
```

The outlet valve has only two conditions, i.e. open and close, so that the judgement of the normal condition or abnormal condition of the micropump is effected merely by detecting whether the outlet valve is open or closed. In detail, the judgement is carried out when the voltage is compared to the standard voltage after a predetermined length of time has lapsed from the moment when it rises in order to see whether the voltage is a high voltage or a low one.

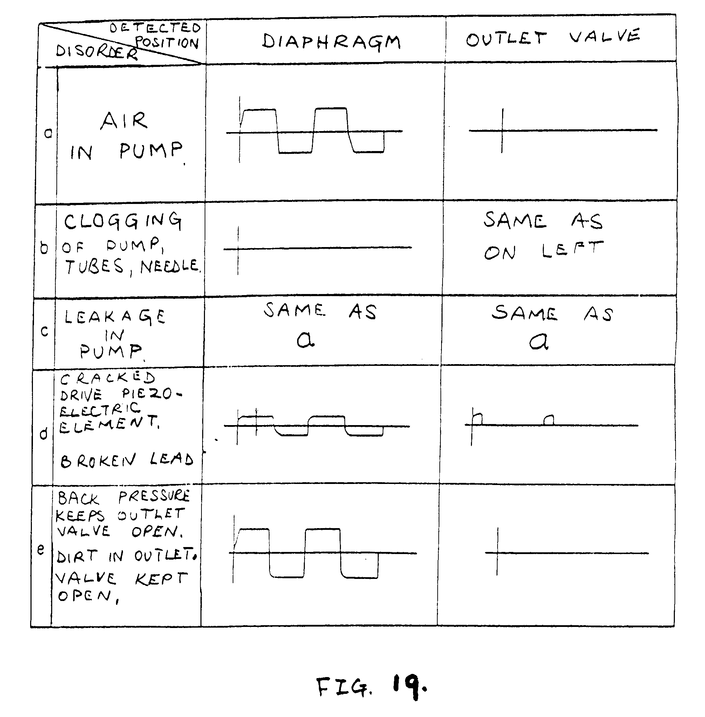

Figure 19 shows the relationship between various disorders of the micropump and the output waveshapes of the detection piezo-electric elements.

(a) concerns the case in which there is air in the micropump.

The pressure merely compresses the air, and so the waveshape of the diaphragm has a sharp rising portion and vibrates up-and-down. The waveshape at the outlet valve portion shows little vibration.

(b) concerns the case in which the pump mechanism, tube, or needle is clogged.

The diaphragm and outlet valve portion are substantially free of vibration.

(c) concerns the case in which there is a leak in the pump.

The effect is the same as in (a).

(d) concerns the case in which the drive piezo-electric element cracks or in which there is a broken lead.

The amplitudes at the diaphragm and the outlet valve decrease or no output is obtained.

(e) concerns the case in which the outlet valve opens due to back pressure or due to dirt which clogs up the outlet.

Resistance in the valve body is diminished and liquid at the outlet side flows alternately or to and fro, so that the detected waveshape has a sharp rising portion and vibrates up-and-down. The waveshape detected at the outlet valve has almost no vibration.

In addition, the detection above is carried out only on the positive side of the waveshapes to be detected and the negative side is cancelled by means of a diode.

As described above, when a disorder happens, a little or large deformation appears to a greater or smaller extent in the waveshape generated. The instants when the media flowing through the micropump changes from a compressible one to a noncompressible one or vice versa can be detected through the detected waveshapes.

Figure 20 shows a ninth embodiment of a micropump according to the present invention in which prepressure is used to provide sealing portions 43 and 53 at the inlet valve and outlet valve. The micropump shown in Figure 20 has a substrate 1 and a pair of adhering membranes 19 and 20 made of metal plating such as Si, Au, and Ag adhered to the substrate 1. Providing such adhering membranes on the substrate 1 as described above is easier than that on the valve bodies and it is possible to obtain a contact surface of a uniform thickness.

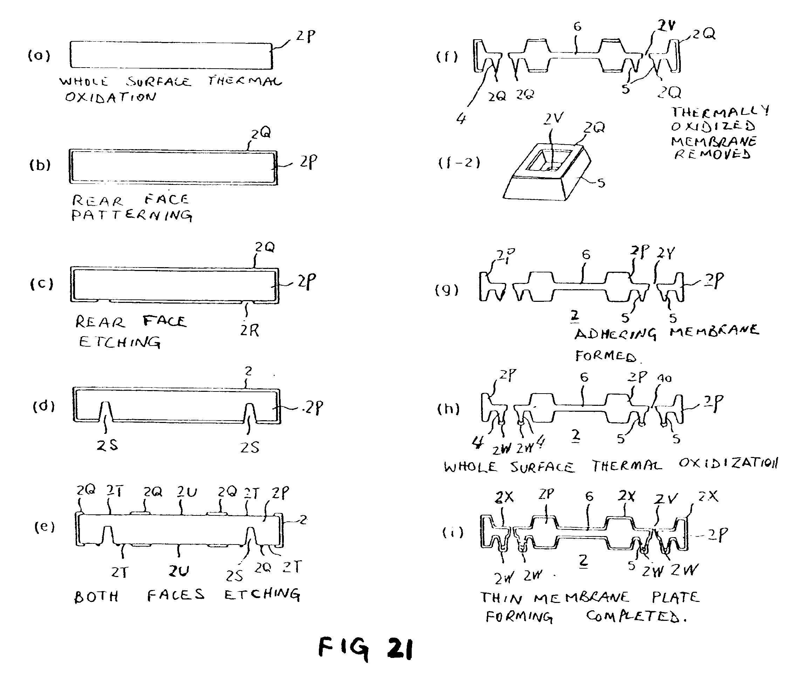

The manufacturing method employed to produce the thin membrane plate, which is an important member of the micropump according to the present invention, will now be explained with reference to Figure 21. Each manufacturing process and condition at respective steps will be explained in the order of the steps (a) - (i) shown in Figure 21.

Example 1

First, in the step (a), both faces of a silicon wafer of face-direction (100) (crystal face) are polished and washed in order to make a substrate 2P of a thickness 280 microns. The substrate 2P is thermally oxidized in an atmosphere of $O_2$ at 1100°C, for an hour.

In the step (b), an oxidized membrane ($SiO_2$ membrane) 2Q of 0.13 microns is formed on the whole surface of the substrate made in the step (a).

Next, in the step (c), a resist patterning is carried out on the oxidized membrane 2Q formed at the rear face of the substrate 2P in order to remove the oxidized membrane 2Q at its pattern portion by means of hydrofluoric acid etching liquid. Thus, an etching mask pattern 2R for use in a first etching process is provided, the pattern having through holes.

A first anisotropy etching step of the silicon on a part of the etching mask pattern 2R is carried out in order to form non-through holes 2S of a depth of 150 microns in the step (d). The etching step of the substrate 2P is carried out by immersing it in an etching liquid of ethylenediamine.pyrocatechol water (mol ratio 35 : 5 : 60) after it is formed, as shown in (c), and the liquid is heated to 110°C for 2 hours. In order to prevent the etching liquid from evaporating, the etching is carried out by a liquid return method. The non-through holes 2S only have a depth of 150 microns and do not pass through the substrate 2P. Consequently, it is possible to handle the wafer with a vacuum chucking means (not shown) and to control the size of other through holes (described hereinafter).

The patterning of both the oxidized surfaces of membrane 2Q for producing a diaphragm, valves, and flow conduits is carried out in the manner described above in order to form an etching mask pattern 2T for producing valves and another etching mask pattern 2U for producing a diaphragm as shown in (e).

A second anisotropy etching step (f) is carried out on the silicon of the parts of both etching mask patterns 2T and 2U according to the condition above and using the same etching liquid as above. The depths of the etching are 110 microns on each side of the substrate 2P, and a diaphragm 6 of a thickness of 60 microns and valve membranes of the valves 4 and 5 are formed. Through holes 2V are formed at the centres of the valve membranes as shown in the enlarged view (f-2) of Figure 21. As shown, the oxidized membrane 2Q of the valves 4 and 5 surrounds the central portion of the valve membrane.

After that, hydrofluoric acid solution removes the oxidized membrane 2Q making the shape shown in (g) and then the step (h) is carried out.

In the step (h), in order to form adhering membranes 2W of a thickness 1 micron on the valve portions of the substrate, a mask spattering is carried out on the $SiO_2$ membrane. In the mask patterning process, a metal mask, which has been formed to remove the parts of the valves 4 and 5 in a separate step, is applied correspondingly to the substrate 2P. Then a regular high-frequency spattering process is carried out on the $SiO_2$ membrane in order to deposit $SiO_2$ of 1 micron on the valves 4 and 5, resulting in the generation of an adhering membrane 2W. The conditions of spattering are Ar spatter gas pressure of $3 \times 10^{-3}$ Torr; RF power 400W; a substrate temperature 200°C; and treatment for one hour thirty minutes.

Further,the whole of the surfaces of the substrate after step (h) are thermally oxidized as described above in order to form an oxidized membrane 2X of a thickness 0.13 microns as shown in (i) on both surfaces. This whole-surface thermal oxidizing process is carried out to improve anti-corrosive properties of the micropump, which is necessary when the pumping liquid is a chemical and to make the flow of the liquid easy. In the oxidizing process, the conduits through which the liquid flows (see example II below) are given an improved wetting power and a resistance to chemicals. Thus, as shown in the step (i), a thin membrane plate 2 for a micropump is obtained leaving about 1 micron of the adhering membrane 2W made of an oxidized membrane at the valves 4 and 5.

The purpose of manufacturing the adhering membrane 2W of $SiO_2$ at the parts of the valves 4 and 5 on the thin membrane plate 2 above is to prevent the adhering membrane 2 of the valves 4 and 5 from coming in contact with glass in the anode jointing process of the assembling of the micropump after that (see Example II below).

The forming process of the adhering membrane 2W has been explained with reference to the mask spattering of (f) - (h) in the previous Example I. However, the adhering membrane may alternatively be formed according to one of the two methods below.

According to a first method, a 1 micron thick $SiO_2$ membrane is formed on the whole surface of the substrate using a pressure-reduced CVD (chemical vapour deposition) in a gas atmosphere of $SiH_4$ gas + $O_2$, at 400°C and a rate of CVD of 100 Å/minute, and for 100 minutes. A resist pattern is formed on the parts for the valves 4 and 5 and the $SiO_2$ membrane, except for the parts for the valves 4 and 5, is removed by hydrofluoric acid etching liquid.

According to a second method, an ordinary wet thermal oxidization forms a 1 micron thick $SiO_2$ membrane on the whole surface of the substrate, and the $SiO_2$ membrane is left only on the parts for the valves 4 and 5 similarly to the previous method.

According to the characteristics of the method for forming the membrane plate 2, (1), etching on the rear face of the substrate forms a non-through hole 2S, and both-face etching forms a through hole 2V at the centre of the valve membrane, (2), the adhering membrane 2W is formed by something such as a mask spattering process on the parts of the valves 4 and 5 which come in contact with glass in order to prevent the valves and the glass from being welded to each other in the assembly step of the micropump.

Example II

According to the Example II, an assembly method for use with the micropump using the thin membrane plate formed by the manufacturing method of Example I as a pump main body will now be explained.

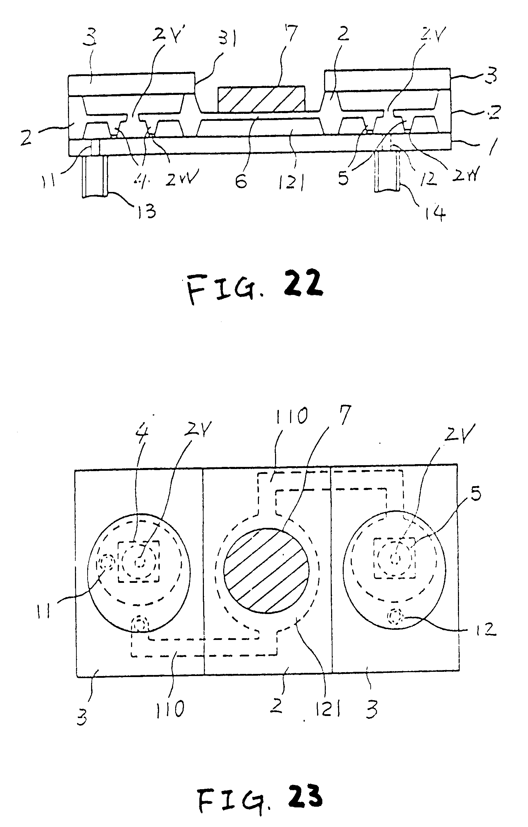

Figures 22 and 23 are sectional views illustrating a method of assembling a micropump manufactured by the method described above. Figure 22 is a longitudinal section and Figure 23 is a cross-section. In Figure 22, the thin membrane plate 2 has no depiction of a thin oxidized membrane 2X.

As is clearly shown, the thin membrane plate 2 provided with a diaphragm 6, valves 4 and 5 having adhering membranes 2W at their ends, and conduits 110 is correctly adhered to a lower glass plate 1 at predetermined positions (the adherence method employed will be explained later). An upper glass plate 3 is secured to the top surface of the membrane plate 2 in order to form conduits 110 and pumping chambers 121 connected thereto. The upper and the lower glass plates 3 and 1 are made of borosilicate glass of a thickness: 1 mm. Holes to be used as a liquid supply port 11 and a liquid discharge port 12 are previously made in the lower glass plate 1, and a hole 31 in which a piezo-electric element 7 is disposed is formed in the upper glass plate 3 at a position above the diaphragm 6. The micropump in the condition prior to an adhering step as shown in Figure 22 is heated as a whole to 400°C and then an anode jointing step, as referred to above, is carried out in which the side of the thin membrane plate 2 is made a positive pole and the side of the lower glass plate 1 is made a negative pole. A DC current voltage 1000 V is impressed for 10 minutes. Further, another anode jointing is carried out after making the lower glass plate 1, to which the thin membrane plate 2 is bonded as mentioned above, a positive pole, and the upper glass plate 3 a negative pole. After the two-stage anode jointing, the upper and the lower glass plates 1 and 3, and the thin membrane plate 2 except for the adhering membranes 2W are secured together.

Because the oxidized membrane 2X has a thickness as thin as 0.13 microns, it is possible to join by an anode jointing process. However, the adhering membrane 2W is made of an oxidized membrane having a thickness of 1 micron so that an anode jointing process cannot be carried out on the adhering membrane 2W, resulting in the possibility of using a manufacturing method of the micropump as described above.

After an anode jointing process has been carried out on the micropump, the valves 4 and 5 protrude or rise from the bottom face of the thin membrane plate 2 by the thickness of the adhering membrane 2W and pre-pressure is applied to the valve membranes of the valves 4 and 5. The adhering membranes 2W are compressed onto the lower glass plate 1 by its thickness of 1 micron. However, the valves 4 and 5 are not welded to the glass plate since glass cannot be anodically joined to a $SiO_2$ membrane, resulting in a good seal of the valves in the micropump.

After that, the supply tube 13 is joined to the bottom of the supply port 11, and the discharge tube 14 is joined to the bottom of the discharge port 12. Thus the main construction of the micropump is completed.

The manufacture of the micropump then enters a final step. The explanation of this step has been with reference to one micropump main body. However, in practice, a plurality of the same patterns are formed on one silicon wafer. A die is used to cut out pieces of the silicon wafer for one micropump, the piezo-electric element (disc) 7 is secured on the upper surface of the diaphragm 6, electric wiring (not shown) for the piezo-electric element is made, and tubings (not shown) are attached to the supply port 11 and to the discharge port 12, so obtaining a micropump.

It is apparent that the manufacturing method described above is not limited to micropumps having the constructions described with reference to the Examples above. It is possible to apply the method to other micropumps of other constructions and to similar devices for controlling fluid. For example, no through hole 2V need be provided at the side of the outlet valve, or the three-valve system may be employed in the micropump, and in either case, the manufacturing method of the present invention can be employed.

## Claims

1. A micropump comprising a substrate (1) having an inlet port (11) and an outlet port (12); pump plate means (2) mounted on the substrate (1), portions of the pump plate means (2) forming an inlet valve (4) and an outlet valve (5) which respectively control flow through the inlet port (11) and the outlet port (12), the outlet valve (5) covering an inlet (12a) of the outlet port (12) so that, when the outlet valve (5) is closed, it caps the outlet port (12); a diaphragm (6) which is an integral part of the pump plate means (2) and which forms at least part of a wall of a pump chamber (121) in the pump plate means (2), the pump plate means (2) having conduit means (111-120,122) for the flow of fluid from the inlet port (11) and via the pump chamber (121) to the outlet port (12); and drive means (7) for effecting pumping movement of the diaphragm (6), the outlet valve (5) being provided with an outlet valve chamber (113) which communicates with the inlet port (11), and fluid in the outlet valve chamber (113) urging the outlet valve (5) towards its closed position, characterised in that the pump plate means (2) has an annular inlet valve chamber (116) therein which surrounds the inlet valve (4) and which communicates with the outlet valve chamber (113).

2. A micropump as claimed in claim 1 in which the pump plate means is constituted by a single plate member (2).

3. A micropump as claimed in any preceding claim characterised in that the drive means comprises a piezo-electric element (7) secured to the diaphragm (6).

4. A micropump as claimed in any preceding claim characterised in that the pump plate means (2) are sandwiched between the substrate (1) and a top plate (3).

5. A micropump as claimed in any preceding claim characterised in that the outlet valve (5) is provided with a detection member for detecting the position or behaviour of the outlet valve (5).

6. A micropump as claimed in any preceding claim characterised in that the outlet valve (5) covers an inlet (12a) of the outlet port (12) so that, when the outlet valve (5) is closed, it caps the outlet port (12).

7. A micropump as claimed in any preceding claim characterised in that the substrate comprises both a base plate (1) and a support plate (21) mounted on the base plate (1), the support plate (21) supporting the pump plate means (2) and being provided with transversely extending inlet and outlet ports (11, 12).

8. A micropump as claimed in claim 1 characterised in that the pump plate means comprises first and second plates, the first plate being provided with the inlet valve (4) and the pump chamber, and the second plate being provided with the outlet valve (5).

9. A micropump as claimed in any preceding claim characterised in that the diaphragm (6) is provided adjacent its centre with a support member (81) or a support portion (83) engageable with the substrate (1).

10. A micropump as claimed in any preceding claim characterised in that detection means (100) are provided for detecting strain in the drive means (7) and/or for detecting mechanical displacement of the diaphragm (6).

11. A micropump as claimed in any preceding claim in which at least one of the valves (4, 5) is provided with or engages a member (43,53;2W) for assisting the sealing of the valve (4,5) to the substrate (1) and/or for preventing undesired adherence therebetween.

12. A micropump as claimed in any preceding claim characterised in that the drive means comprises a dielectric member (7A), the diaphragm (6) being oscillated by the static electricity of the dielectric member (7A).

**Patentansprüche**

1. Mikropumpe mit einem Substrat (1) mit einer Einlaßöffnung (11) und einer Auslaßöffnung (12); mit einer auf dem Substrat (1) angebrachten Pumpenplatteneinrichtung (2), wobei Bereiche der Pumpenplatteneinrichtung (2) ein Einlaßventil (4) und ein Auslaßventil (5) bilden, die jeweils die Strömung durch die Einlaßöffnung (11) bzw. die Auslaßöffnung (12) steuern, wobei das Auslaßventil (5) einen Einlaß (12a) der Auslaßöffnung (12) bedeckt, so daß bei geschlossenem Auslaßventil (5) dieses die Auslaßöffnung (12) überdeckt; mit einer Membran (6), die integraler Bestandteil der Pumpenplatteneinrichtung (2) ist und die wenigstens einen Teil einer Wand einer Pumpenkammer (121) in der Pumpenplatteneinrichtung (2) bildet, wobei die Pumpenplatteneinrichtung (2) eine Kanaleinrichtung (111 - 120, 122) für die Fluidströmung von der Einlaßöffnung (11) über die Pumpenkammer (121) zu der Auslaßöffnung (12) aufweist; und mit einer Antriebseinrichtung (7) zum Bewirken einer Pumpbewegung der Membran (6), wobei das Auslaßventil (5) mit einer Auslaßventilkammer (113) versehen ist, die mit der Einlaßöffnung (11) kommuniziert, und wobei Fluid in der Auslaßventilkammer (113) das Auslaßventil (5) in Richtung auf seine geschlossene Stellung drückt, dadurch gekennzeichnet, daß in der Pumpenplatteneinrichtung (2) eine ringförmige Einlaßventilkammer (116) vorgesehen ist, die das Einlaßventil (4) umgibt und mit der Auslaßventilkammer (113) kommuniziert.

2. Mikropumpe nach Anspruch 1,
wobei die Pumpenplatteneinrichtung durch ein einziges Plattenelement (2) gebildet ist.

3. Mikropumpe nach einem der vorausgehenden Ansprüche,
dadurch gekennzeichnet, daß die Antriebseinrichtung ein an der Membran (6) befestigtes piezoelektrisches Element (7) aufweist.

4. Mikropumpe nach einem der vorausgehenden Ansprüche,
dadurch gekennzeichnet, daß die Pumpenplatteneinrichtung (2) sandwichartig zwischen dem Substrat (1) und einer oberen Platte (3) angeordnet ist.

5. Mikropumpe nach einem der vorausgehenden Ansprüche,
dadurch gekennzeichnet, daß das Auslaßventil (5) mit einem Detektionselement zum Detektieren der Position oder des Verhaltens des Auslaßventils (5) versehen ist.

6. Mikropumpe nach einem der vorausgehenden Ansprüche,
dadurch gekennzeichnet, daß das Auslaßventil (5) einen Einlaß (12a) der Auslaßöffnung (12) bedeckt, so daß bei geschlossenem Auslaßventil (5) dieses die Auslaßöffnung (12) überdeckt.

7. Mikropumpe nach einem der vorausgehenden Ansprüche,
dadurch gekennzeichnet, daß das Substrat sowohl eine Basisplatte (1) als auch eine auf der Basisplatte (1) angebrachte Tragplatte (21) aufweist, wobei die Tragplatte (21) die Pumpenplatteneinrichtung (2) trägt und mit einer Einlaß- und einer Auslaßöffnung (11, 12) versehen ist, die sich quer zu dieser erstrecken.

8. Mikropumpe nach Anspruch 1,
dadurch gekennzeichnet, daß die Pumpenplatteneinrichtung eine erste und eine zweite Platte aufweist, wobei die erste Platte mit dem Einlaßventil (4) und der Pumpenkammer versehen ist und die zweite Platte mit dem Auslaßventil (5) versehen ist.

9. Mikropumpe nach einem der vorausgehenden Ansprüche,
dadurch gekennzeichnet, daß die Membran (6) angrenzend an ihre Mitte mit einem zum Angreifen an dem Substrat (1) ausgelegten Trägerelement (81) oder Trägerbereich (83) versehen ist.

10. Mikropumpe nach einem der vorausgehenden Ansprüche,
dadurch gekennzeichnet, daß Detektionseinrichtungen (100) zum Detektieren einer Verformung in der Antriebseinrichtung (7) und/oder zum Detektieren einer mechanischen Verlagerung der Membran (6) vorgesehen sind.

11. Mikropumpe nach einem der vorausgehenden Ansprüche,
wobei wenigstens eines der Ventile (4, 5) mit einem Element (43, 53; 2W) zum Unterstützen der dichten Anordnung des Ventils (4, 5) an dem Substrat (1) und/oder zum Verhindern eines unerwünschten Anhaftens zwischen diesen versehen ist oder an diesem Element angreift.

12. Mikropumpe nach einem der vorausgehenden Ansprüche,
dadurch gekennzeichnet, daß die Antriebseinrichtung ein dielektrisches Element (7A) aufweist, wobei die Membran (6) durch die statische Elektrizität des dielektrischen Elements (7A) in Schwingung versetzt wird.

**Revendications**

1. Une micropompe comprenant un substrat (1) présentant un orifice d'entrée (11) et un orifice de sortie (12); des moyens formant la plaque de pompe (2) montés sur le substrat (1), des parties des moyens formant la plaque de pompe (2) constituant une valve d'entrée (4) et une valve de sortie (5) qui commandent respectivement l'écoulement par l'orifice d'entrée (11) et l'orifice de sortie (12), la valve de sortie (5) recouvrant une entrée (12a) de l'orifice de sortie (12) de sorte que, quand la valve de sortie (5) est fermée, elle recouvre l'orifice de sortie (12); un diaphragme (6) qui fait partie intégrante des moyens formant la plaque de pompe (2) et qui définit au moins une partie d'une paroi d'une chambre de la pompe (121) dans les moyens formant la plaque de pompe (2), les moyens formant la plaque de pompe (2) présentant des moyens formant conduite (111-120, 122) pour l'écoulement de fluide à partir de l'orifice d'entrée (11) et via la chambre de pompe (121) vers l'orifice de sortie (12); et des moyens d'entraînement (7) pour provoquer un déplacement de pompage du diaphragme (6), la valve de sortie (5) étant munie d'une chambre de valve de sortie (113) qui communique avec l'orifice d'entrée (11), et du fluide dans la chambre de valve de sortie (113) sollicitant la valve de sortie (5) vers sa position fermée, caractérisée en ce que les moyens définissant la plaque de pompe (2) comportent une chambre annulaire pour la valve d'entrée (116), lesdits moyens entourant valve d'entrée (4) et communiquant avec la chambre de la valve de sortie (113).

2. Une micropompe selon la revendication 1, dans laquelle les moyens formant la plaque de pompe sont constitués d'un seul élément en forme de plaque (2).

3. Une micropompe selon l'une quelconque des revendications précédentes, caractérisée en ce que les moyens d'entraînement comprennent un élément piézoélectrique (7) fixé au diaphragme (6).

4. Une micropompe selon l'une quelconque des revendications précédentes, caractérisée en ce que les moyens formant la plaque de pompe (2) sont pris en sandwich entre le substrat (1) et une plaque supérieure (3).

5. Une micropompe selon l'une quelconque des revendications précédentes, caractérisée en ce que la valve de sortie (5) est munie d'un organe de détection pour détecter la position ou le comportement de la valve de sortie (5).

6. Une micropompe selon l'une quelconque des revendications précédentes, caractérisée en ce que la valve de sortie (5) recouvre une entrée (12a) de l'orifice de sortie (12) de sorte que, quand la valve de sortie (5) est fermée, elle recouvre l'orifice de sortie (12).

7. Une micropompe selon l'une quelconque des revendications précédentes, caractérisée en ce que le substrat comprend une plaque de base (1) ainsi qu'une plaque de support (21) montée sur la plaque de base (1), la plaque de support (21) supportant les moyens formant la plaque de pompe (2) et étant munie d'orifices d'entrée et de sortie qui s'étendent dans le sens transversal (11, 12).

8. Une micropompe selon la revendication 1, caractérisée en ce que les moyens formant la plaque de pompe comprennent des premières et deuxième plaques, la première plaque étant munie d'une valve d'entrée (4) et de la chambre de pompe, et la deuxième plaque étant munie de la valve de sortie (5).

9. Une micropompe selon l'une quelconque des revendications précédentes, caractérisée en ce que le diaphragme (6) comporte, à proximité de son centre, un organe de support (81) ou une zone de support (83) susceptible d'être engagée avec le substrat (1).

10. Une micropompe selon l'une quelconque des revendications précédentes, caractérisée en ce que des moyens de détection (100) sont prévus pour détecter une contrainte dans les moyens d'entraînement (7) et/ou pour détecter le déplacement mécanique du diaphragme (6).

11. Une micropompe selon l'une quelconque des revendications précédentes, dans laquelle au moins une des valves (4, 5) comporte un organe (43, 53; 2W) ou vient en prise avec ce dernier, cet organe aidant l'étanchéité entre la valve (4, 5) et le substrat (1) et/ou empêchant une adhérence indésirable entre la valve et le substrat.

12. Une micropompe selon l'une quelconque des revendications précédentes, caractérisée en ce que les moyens d'entraînement comprennent un organe diélectrique (7A), l'électricité statique de l'organe diélectrique (7A) faisant osciller le diaphragme (6).

FIG. 1

FIG. 8

FIG. 2

FIG. 3

FIG. 4

FIG 5 (a)

FIG.5 (b)

FIG. 6

FIG. 7

FIG. 9

FIG. 10(a)

FIG. 10(b)

FIG. 10(c)

FIG. 11

FIG. 12

FIG. 13

21

FIG. 14

FIG. 20

**FIG 15.**

**FIG. 16(a)**

**FIG. 16 (b)**

FIG. 17

FIG. 18

| DETECTED POSITION / DISORDER | DIAPHRAGM | OUTLET VALVE |
|---|---|---|
| a  AIR IN PUMP. | | |
| b  CLOGGING OF PUMP, TUBES, NEEDLE. | | SAME AS ON LEFT |
| c  LEAKAGE IN PUMP. | SAME AS a | SAME AS a |
| d  CRACKED DRIVE PIEZO-ELECTRIC ELEMENT. BROKEN LEAD | | |
| e  BACK PRESSURE KEEPS OUTLET VALVE OPEN. DIRT IN OUTLET. VALVE KEPT OPEN, | | |

FIG. 19.

EP 0 435 653 B1

(o) 2P

WHOLE SURFACE THERMAL
OXIDATION

(b) 2Q 2P

REAR FACE
PATTERNING

(c) 2Q 2P 2R

REAR FACE
ETCHING

(d) 2 2P 2S 2S

(e) 2Q 2T 2Q 2U 2Q 2T 2P 2 2T 2U 2S 2Q 2T

BOTH FACES ETCHING

(f) 6 2V 2Q 4 2Q 2Q 5 2Q

(f-2) 2V 2Q 5

THERMALLY
OXIDIZED
MEMBRANE
REMOVED

(g) 2P 6 2P 2V 2P 2 5 5

ADHERING MEMBRANE
FORMED

(h) 2P 6 2P 40 2P 4 2W 2W 4 2 5 5

WHOLE SURFACE THERMAL OXIDIZATION

(i) 2X 2P 6 2X 2V 2X 2P 2W 2W 2 5 2W 2W

THIN MEMBRANE PLATE
FORMING COMPLETED.

FIG 21

FIG. 22

FIG. 23

FIG. 24

FIG. 25